Europäisches Patentamt

European Patent Office

Office européen des brevets

(19)

(11) Veröffentlichungsnummer: **0 101 789**
**B1**

(12) **EUROPÄISCHE PATENTSCHRIFT**

(45) Veröffentlichungstag der Patentschrift:
**17.11.88**

(21) Anmeldenummer: **83103761.9**

(22) Anmeldetag: **19.04.83**

(51) Int. Cl.⁴: **H 03 H 7/46**

(54) Filterschaltung.

(30) Priorität: **30.07.82 DE 3228449**

(43) Veröffentlichungstag der Anmeldung:
**07.03.84 Patentblatt 84/10**

(45) Bekanntmachung des Hinweises auf die Patenterteilung:
**17.11.88 Patentblatt 88/46**

(84) Benannte Vertragsstaaten:
**AT BE CH DE GB IT LI LU NL SE**

(56) Entgegenhaltungen:
**DE - A - 2 238 716**
**DE - A - 3 027 235**

(73) Patentinhaber: **Richard Hirschmann Radiotechnisches Werk, Richard-Hirschmann-Strasse 19 Postfach 110, D-7300 Esslingen a.N. (DE)**

(72) Erfinder: **Wendel, Wolfgang, Dipl.-Ing., Steinbruchstr. 62, D-7316 Köngen (DE)**

(74) Vertreter: **Stadler, Heinz, Dipl.-Ing., Richard Hirschmann Radiotechnisches Werk Richard-Hirschmann-Strasse 19, D-7300 Esslingen a.N. (DE)**

**Beschreibung**

Die Erfindung betrifft eine Filterschaltung zum Sperren bzw. Durchlassen von Teilfrequenzbereichen, mit wenigstens zwei Resonanzfrequenzkreisen für jeden Teilfrequenzbereich.

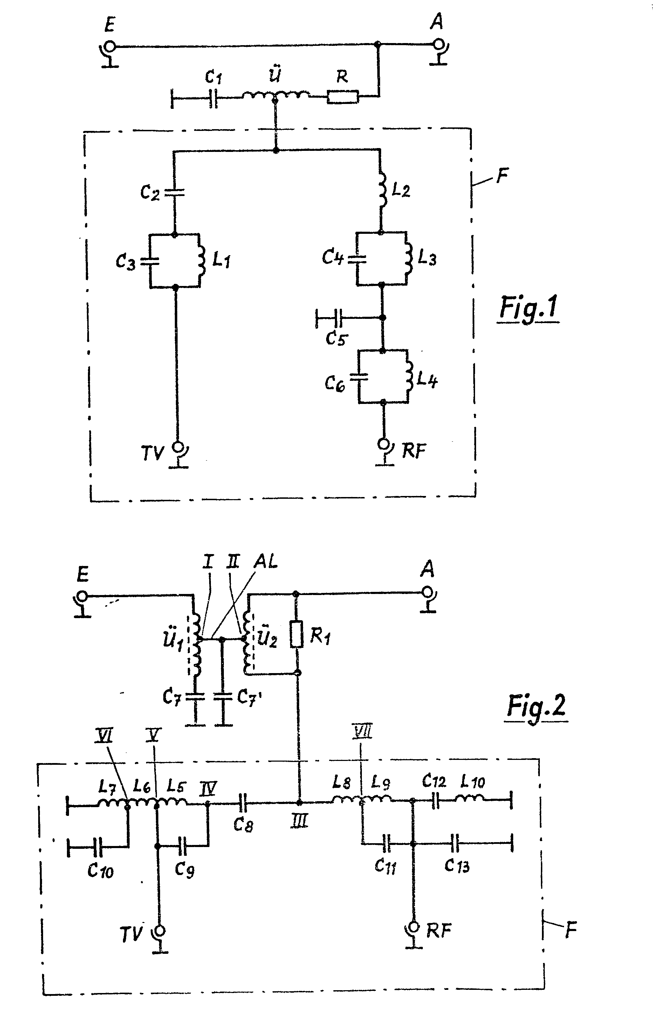

Solche Filterschaltungen sind allgemein bekannt und beispielsweise als Frequenzweiche für Antennensteckdosen zum Auftrennen in Rundfunkbereiche (LMKU) und Fernsehbereiche (VHF, UHF, SHF) ausgebildet. Im Vergleich zu einkreisigen oder lediglich aus einem Blindwiderstand je Teilfrequenzbereich bestehenden Filtern, wie sie z.B. von der Antennensteckdose Gedu 2411 der Anmelderin bekannt sind, deren Schaltbild in Fig. 1 dargestellt ist, sind damit wesentlich günstigere Werte für Sperrdämpfung, Flankensteilheit, Durchgangs- und Rückflussdämpfung erreichbar. Solche Werte sind etwa dann erforderlich, wenn in Gemeinschaftsantennenanlagen Antennensteckdosen geringer Anschlussdämpfung kaskadiert werden.

Bei derartigen Antennensteckdosen, die die HF-Energie z.B. über einen Anpassungs- und einen Differentialübertrager auf der Stammleitungsausgang und den Filtereingang aufteilen, ist zwischen diesen beiden Anschlüssen eine Koppeldämpfung von nur etwa 20 dB (im UHF-Bereich) erreichbar. Auf der anderen Seite ist gemäss den Vorschriften der Deutschen Bundespost (Amtsblatt Nr. 125/ 1971 und FTZ-Richtlinie 1R8–15) für die Entkoppelung zwischen dem Rundfunk- und dem Fernsehanschluss beliebiger Antennensteckdosen ein Wert von mindestens 50 dB gefordert, um einen insoweit störungsfreien Empfang an den Teilnehmeranschlüssen zu gewährleisten. Die dazu erforderliche Sperrdämpfung des Filters beträgt somit z.B. bei einer Anschlussdämpfung von 5 dB mindestens 25 dB und wird nur mit Filterschaltungen der eingangs genannten Art erreicht, die wenigstens zwei Resonanzkreise für jeden Teilfrequenzbereich aufweisen. Sie erfordern jedoch einen hohen Bauteileaufwand und kommen damit für die meisten praktischen Anwendungsfälle, wie z.B. Antennensteckdosen, sowohl aus Kostengründen als auch wegen des grossen Platzbedarfs nicht in Betracht.

Der Erfindung liegt daher die Aufgabe zugrunde, eine Filterschaltung der eingangs genannten Art zu schaffen, die mit möglichst wenig Bauteilen kostengünstig herstellbar ist und dabei möglichst gute Dämpfungswerte, insbesondere eine hohe Sperrdämpfung aufweist.

Diese Aufgabe ist dadurch gelöst, dass die Resonanzkreise derart aufgebaut und bemessen sind, dass jedes Bauelement eines jeden Resonanzkreises zugleich Bestandteil mindestens eines weiteren Resonanzkreises für einen anderen Teilfrequenzbereich ist.

Es ist zwar von aus Einzelkreisen aufgebauten Filterschaltungen bereits seit langem bekannt (s. z.B. Meinke/Gundlach, Taschenbuch der Hochfrequenztechnik, Springer-Verlag, 1962, S. 188/189), einzelne Blindwiderstände als Teilreaktanzen zweier Einzelresonanzkreise für je einen Teilfrequenzbereich auszunutzen. Eine konsequente Anwendung dieser Massnahme auf Filter mit mehrkreisigen Teilfrequenzbereichs-Zweigen war daraus dem Fachmann aber offensichtlich nicht nahegelegt, weil sie über Jahrzehnte nicht erfolgt ist, obwohl diese Massnahme durch den Einsatz der Filterschaltungen in Massenartikeln wie z.B. Antennensteckdosen, bei denen die Einsparung von Bauteilen zu den Grundaufgaben des Konstrukteurs gehört, besonders wirksam ist.

Durch die erfindungsgemässe Doppel- bzw. Mehrfachnutzung aller Bauelemente der Filterschaltung sind mit einer denkbar geringen Anzahl von Schaltungsbauteilen, die etwa derjenigen der bekannten Einzelkreislösung entspricht, die elektrischen Daten von Schaltungen erreicht, bei denen für jeden Teilfrequenzbereich ein besonderes Zweikreisfilter vorgesehen ist. Die Sperrdämpfung dieser Filterschaltung ist so hoch, dass zum Beispiel die geforderte Entkopplung von wenigstens 50 dB zwischen den Rundfunk- und Fernsehanschlüssen benachbarter Antennensteckdosen in allen Nutzfrequenzbereichen selbst dann noch gewährleistet ist, wenn im Extremfall die eine Antennensteckdose (Durchschleifdose) eine Anschlussdämpfung von 3 dB aufweist und die andere (Enddose ohne Verteiler) eine solche von ca. 1 dB. Darüberhinaus ist eine Durchgangsdämpfung von max. 1 dB, eine hohe Rückflussdämpfung, sowie ein sehr gleichmässiger Frequenzgang der Übertragungsfunktion in allen Teilfrequenzbereichen erreicht. Damit eignet sich die erfindungsgemässe Filterschaltung z.B. sehr gut für die Verwendung in hintereinandergeschalteten Antennensteckdosen mit geringer Anschlussdämpfung.

Schliesslich liegen bei der erfindungsgemässen Filterschaltung die Induktivitätswerte der Spulen so günstig, dass diese selbst auf sehr kleinen Flächen wie der Einsatzplatine einer Antennensteckdose für 55 mm-Unterputzmontage in gedruckter Form ausführbar sind. Auf diese Weise ist ein äusserst einfacher, kostengünstiger und exakter Aufbau der Filterschaltung auf kleinstem Raum ermöglicht, der sich in besonderem Masse für die Serienfertigung eignet.

Dieser Vorteil wird noch verstärkt durch eine Ausgestaltung der Erfindung gemäss Anspruch 2, die ohne Mehrkosten eine weitere Reduzierung des Platzbedarfs erlaubt.

Durch die bei Zusammenfassung mehrerer Teilspulen zu einer einzigen Spule erhöhte Induktivität und bei engem räumlichen Aufbau kann die Eigenresonanz der Spule in einen Nutzfrequenzbereich fallen. Der dadurch bewirkte Einbruch im Frequenzgang der Anschlussdämpfung ist durch den in Anspruch 3 angegebenen Aufbau auf einfache Weise vermeidbar.

In Anspruch 4 sind besonders zweckmässig Konfigurationen der erfindungsgemässen Filterschaltung mit je einem Filterzweig zur getrennten Auskopplung von Rundfunk- und Fernsehbereichen angegeben.

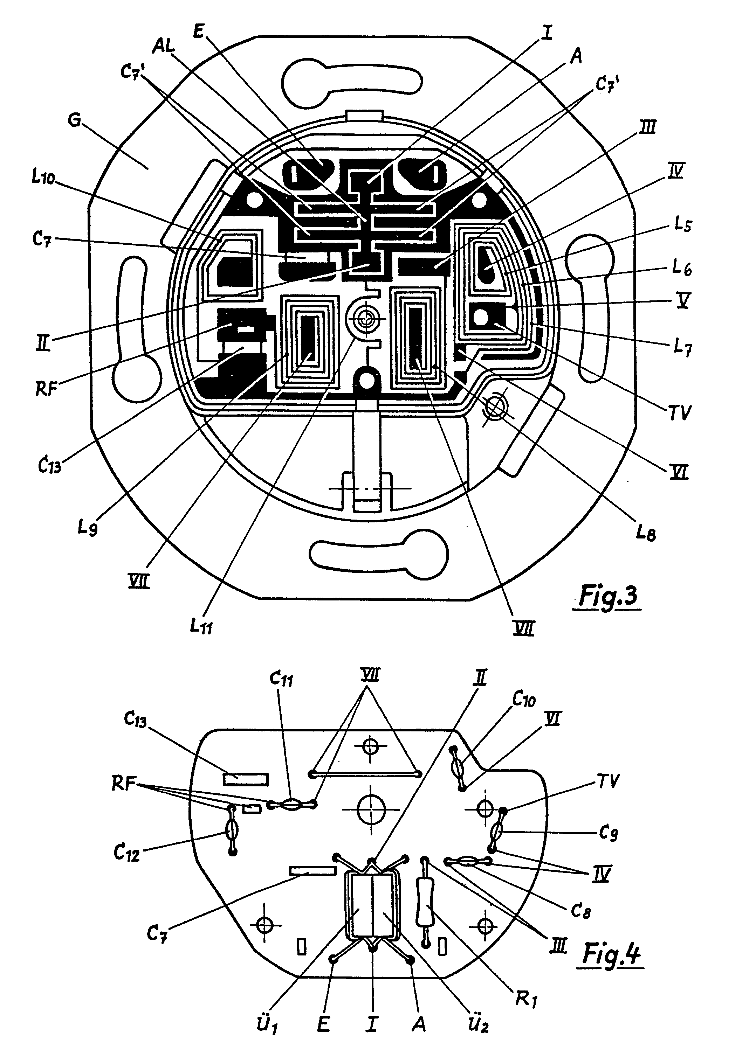

Die Figuren 2 bis 4 zeigen ein Ausführungsbeispiel der erfindungsgemässen Filterschaltung, verwendet in einer Antennensteckdose. Dabei stellt Fig. 2 das Schaltbild dar und die Fig. 3 und 4 jeweils eine Draufsicht, zum einen auf die komplette Antennensteckdose von der der Anschlussseite gegenüberliegenden Seite her und zum anderen auf die Bauteileseite der Schaltungsplatine.

Von dem Eingangsanschluss E wird die Hochfrequenzenergie über einen prinzipiell z.B. aus der DE-AS 2 807 327 bekannten, hier wegen der besseren Kaskadierbarkeit der Antennensteckdose asymmetrisch ausgebildeten Zweifachverteiler auf den Stammleitungsausgangsanschluss A und den Eingang III der Filterschaltung F aufgeteilt. Dabei ist $Ü_1$ der Anpassübertrager, $Ü_2$ der Differentialübertrager, $R_1$ der Entkopplungswiderstand, AL die zur zwangsweise gleichmässigen Aufteilung der Energie vorgesehene Ausgleichsleitung, $C_7$ ein zur Verbesserung der Anpassungswerte bei tiefen Frequenzen vorgesehener Kondensator und $C'_7$ ein Kondensator zur Erhöhung der oberen Grenzfrequenz, der zwischen Ausgleichsleitung AL und Masse eingeschaltet und in Form von kammartig ineinandergreifenden Metallflächen auf der einseitig mit Metallbelag versehenen Trägerplatine ausgebildet ist. Die asymmetrische Anzapfung des Differentialübertragers $Ü_2$ ist so ausgelegt, dass die Durchgangsdämpfung des Verteilers im gesamten Frequenzbereich etwa 2 dB und die Anschlussdämpfung zwischen Eingang E der Antennensteckdose und dem Eingang III der Filterschaltung F ca. 5 dB beträgt.

Die unter Berücksichtigung von beispielsweise durch Schraubklemmen an den Anschlüssen erzeugten Störkapazitäten erreichte Koppeldämpfung zwischen dem Dosenausgang A und dem Filtereingang III beträgt hierbei etwa 20 dB im UHF-Bereich. Im LM-Bereich stellt dagegen der beschriebene Zweifach-Verteiler einen 3 dB-Verteiler ohne Entkopplung dar.

Die Filterschaltung F besteht aus je einem Zweig für Rundfunk und Fernsehen mit den entsprechenden Anschlüssen RF und TV und weist folgende prinzipielle Wirkungsweise auf:

Im Fernsehzweig stellen die Induktivitäten $L_6$, $L_7$ eine Sperre (praktisch Kurzschluss) für den LMK-Bereich dar, $L_5$, $C_9$ und $L_6$, $L_{10}$ eine Bandsperre für UKW, $L_5$, $C_8$ und $L_7$, $C_{10}$ ein Bandfilter für den Fernsehbereich I, sowie die Kapazitäten $C_8$, $C_9$ zusammen mit den Induktivitäten $L_6$, $L_7$ einen Hochpass ab dem Fernsehbereich I.

Im Rundfunkzweig bilden die Induktivitäten $L_8$, $L_9$ und die Kapazitäten $C_{12}$, $C_{13}$ einen Tiefpass für den LMK-Bereich, $L_9$, $C_{11}$ und $L_{10}$, $C_{12}$ eine Bandsperre für den Fernsehbereich I, sowie $L_8$, $C_{11}$ und $L_{10}$, $C_{13}$ ein Bandfilter für den UKW-Bereich. Bei dieser beispielhaften Ausführung der erfindungsgemässen Filterschaltung wirken somit alle Bauteile eines für einen Teilfrequenzbereich bemessenen Resonanzkreises voll als Hochfrequenzbauelement eines weiteren Resonanzkreises für einen anderen Teilfrequenzbereich mit, die Spulen $L_6$, $L_7$ sogar für zwei weitere Resonanzkreise in zwei weiteren Teilfrequenzbereichen. Durch diese Mehrfachausnutzung von Bauelementen ist bei einer geringen Durchgangsdämpfung von max. 1 dB und einer entsprechend hohen Rückflussdämpfung eine Sperrdämpfung von minimal 29 dB in allen zu sperrenden Teilfrequenzbereichen mit einer geringen Anzahl von Bauelementen erreicht, womit die genannten Entkopplungsforderungen der Deutschen Bundespost auch für die höchsten Betriebsfrequenzen und bei der geringen Anschlussdämpfung von hier 5 dB erreicht, bei niedrigeren Frequenzen sogar weit übertroffen wird (> 70 dB im LM-Bereich).

Die sich durch die erfindungsgemässen Massnahmen ergebenden Induktivitätswerte der Spulen liegen sämtliche unter 0,25 µH und konnten daher auch auf der verhältnismässig kleinen Trägerplatine der für einen Einbau in 55-mm-Unterputzdosen vorgesehenen Antennensteckdose in Drucktechnik ausgeführt werden. Dabei sind die Spulen $L_5$, $L_6$, $L_7$ zu einer einzigen Spule mit zwei Anzapfungen V, VI zusammengefasst und bilden auf diese Weise eine sehr kleine räumliche Einheit.

Die Spulen $L_8$/$L_9$ sind dagegen in diesem Ausführungsbeispiel getrennt angeordnet, weil einerseits die Platine auch für Antennensteckdosen mit hoher Anschlussdämpfung verwendbar sein soll, bei denen die beiden Spulen nicht direkt galvanisch miteinander verbunden sind, sondern über ein RC-Glied zur Erhöhung der Anschlussdämpfung im LMK-Bereich und weil zum anderen bei diesem Aufbau in vorteilhafter Weise die Einfügung einer zur Verbesserung der Entkopplung bei hohen Frequenzen dienenden in Drucktechnik ausgeführten Spule $L_{11}$ zwischen den einander in der Symmetrieebene der Platine gegenüberliegenden Masseflächen ermöglicht ist. Grundsätzlich können jedoch selbstverständlich auch die Spulen $L_8$, $L_9$, $L_{10}$ zu einer einzigen Spule zusammengefasst werden, wobei sich ein symmetrischer Aufbau der gesamten Schaltung ergibt. Die Anzahl der Blindwiderstände der Filterschaltung ist dann sogar geringer als bei der aus dem Stand der Technik bekannten «Einkreislösung» gem. Fig. 1.

Bei der beschriebenen Antennensteckdose ist somit eine Filterschaltung geschaffen, bei der mit einem Minimum an elektrischen Bauteilen optimale Hochfrequenz-Eigenschaften erreicht sind, die für Kaskadierung geeignet ist, auch bei kleinen Anschlussdämpfungen eine hohe Sperrdämpfung aufweist und die einen einfachen, weitgehend in Drucktechnik ausführbaren und für die Serienfertigung besonders geeigneten Aufbau ermöglicht, der räumlich klein und kostengünstig herstellbar ist.

**Patentansprüche**

1. Filterschaltung zum Sperren bzw. Durchlassen von Teilfrequenzbereichen, mit wenigstens zwei Resonanzkreisen für jeden Teilfrequenzbereich, dadurch gekennzeichnet, dass die Resonanzkreise derart aufgebaut und bemessen sind, dass jedes Bauelement eines jeden Resonanzkreises zugleich Bestandteil mindestens eines weiteren Resonanzkreises für einen anderen Teilfrequenzbereich ist.

2. Filterschaltung nach Anspruch 1, dadurch gekennzeichnet, dass wenigstens in einem Teil-frequenzbereich alle Induktivitäten ($L_5$, $L_6$, $L_7$) zu einer einzigen Spule mit einer entsprechenden Anzahl von Anzapfungen (V, VI) zusammengefasst sind.

3. Filterschaltung nach Anspruch 2, dadurch gekennzeichnet, dass die äussere Windung ($L_7$) der einzigen Spule ($L_5$, $L_6$, $L_7$) in einer dem Windungsabstand entsprechenden Entfernung wenigstens auf einem Teil ihrer Länge von einer Massefläche umfasst ist, deren Enden nicht miteinander leitend verbunden sind.

4. Filterschaltung nach einem der Ansprüche 1 bis 3, mit je einem Filterzweig zur getrennten Auskopplung von Rundfunk- und Fernsehbereichen, dadurch gekennzeichnet, dass
– der Filterzweig zur Auskopplung der Fernseh-bereiche einen aus einer Kapazität $C_8$ und einem dazu in Serie geschalteten Parallelreso-nanzkreis $L_5$, $C_9$ bestehenden Längszweig auf-weist, dessen Ausgang mit dem Fernsehanschluss (TV) einerseits und mit einem gegen Masse geschalteten, aus einer Induktivität $L_6$ und einem dazu in Serie geschalteten Paral-lelresonanzkreis $L_7$, $C_{10}$ bestehenden Quer-zweig andererseits verbunden ist, wobei die Reaktanzen $L_6$, $L_7$ eine Sperre für den LMK-Bereich, $L_5$, $C_9$ mit $L_6$, $C_{10}$ eine Bandsperre fur UKW, $L_5$, $C_8$ mit $L_7$, $C_{10}$ ein Bandfilter für den Fernsehbereich I und $C_8$, $C_9$ mit $L_6$, $L_7$ einen Hochpass für die Fernsehbereiche IV/V bilden, und dass in dualer Weise
– der Filterzweig zur Auskopplung der Rundfunkbereiche einen aus einer Induktivität $L_8$ und einem dazu in Serie geschalteten Parallelreso-nanzkreis $L_9$, $C_{11}$ bestehenden Längszweig auf-weist, dessen Ausgang mit dem Runfunkanschluss (RF) einerseits sowie einem gegen Masse geschalteten, aus einer Kapazität $C_{13}$ und einem dazu parallel geschalteten Serienre-sonanzkreis $L_{10}$, $C_{12}$ bestehenden Querzweig andererseits verbunden ist, wobei die Reaktan-zen $L_8$, $L_9$ mit $C_{12}$, $C_{13}$ einen Tiefpass für den LMK-Bereich, $L_9$, $C_{11}$ mit $L_{10}$, $C_{12}$ eine Bandsper-re für den Fernsehbereich I und $L_8$, $C_{11}$ mit $L_{10}$, $C_{13}$ ein Bandfilter für den UKW-Bereich bilden.

## Claims

1. Filter circuit for blocking partial frequency ranges or allowing partial frequency ranges to pass, with at least two resonant circuits for each partial frequency range, characterized in that the resonant circuits are constructed and dimensioned in such a way that each component of each resonant circuit is at the same time part of at least one further resonant circuit for another partial frequency range.

2. Filter circuit as in Claim 1, characterized in that in at least one partial frequency range all inductances ($L_5$, $L_6$, $L_7$) are combined to form a single coil with a corresponding number of tabs (V, VI).

3. Filter circuit as in Claim 2, characterized in that the outer turn ($L_7$) of the single coil ($L_5$, $L_6$, $L_7$) is surrounded over at least part of its length at a distance corresponding to the winding pitch by an insulating surface, the ends of which are not conductively connected.

4. Filter circuit as in one of the Claims 1 to 3, each with a filter branch for separate coupling out of radio and television ranges, characterized in that
– the filter branch for coupling out television ranges has a longitudinal branch, consisting of a capacitor $C_8$ and a parallel resonant circuit $L_5$, $C_9$ connected in series with it, the output of which is connected to the television connection (TV) on the one hand and on the other hand with a transverse branch connected to earth, con-sisting of an inductance $L_6$ and a parallel re-sonant circuit $L_7$, $C_{10}$ connected in series with it, with the reactances $L_6$, $L_7$ forming a block for the long, medium, short range, $L_5$, $C_9$ with $L_6$, $C_{10}$ forming a band-stop filter for VHF, $L_5$, $C_8$ with $L_7$, $C_{10}$ forming a band-pass filter for television range I and $C_8$, $C_9$ with $L_6$, $L_7$ forming a high-pass filter for television ranges IV/V, and that in a dual manner
– the filter branch for coupling out radio ranges has a longitudinal branch consisting of an in-ductance $L_8$ and a parallel circuit $L_9$, $C_{11}$ con-nected in series with it, the output of which is connected to the radio connection (RF) on the one hand, and on the other hand to a transverse branch connected to earth, consisting of a ca-pacitor $C_{13}$ and a series resonant circuit $L_{10}$, $C_{12}$ connected in parallel with it, with the reactances $L_8$, $L_9$ with $C_{12}$, $C_{13}$ forming a low-pass filter for the long, medium, short range, $L_9$, $C_{10}$ with $L_{10}$, $C_{12}$ forming a band-stop filter for television range I and $L_8$, $C_{11}$ with $L_{10}$, $C_{13}$ forming a band-pass filter for the VHF range..

## Revendications

1. Circuit de filtrage permettant de couper ou non certaines gammes de fréquences, comprenant au moins deux circuits de résonnance pour chaque gamme de fréquences, caractérisé en ce que les circuits de résonnance soient conçus et dimensionnés de telle sorte que chaque composant de chaque circuit de résonnance soit en même temps partie intégrante d'au moins un autre circuit de résonnance pour une autre gamme de fréquences.

2. Circuit de filtrage selon revendication 1, caractérisé en ce que au minimum dans une gamme de fréquences toutes les inductances ($L_5$, $L_6$, $L_7$) soient regroupées en une seule self disposant d'un nombre correspondant de branchements (V, VI).

3. Circuit de filtrage selon revendication 2, caractérisé en ce que le bobinage extérieur ($L_7$) de la seule self ($L_5$, $L_6$, $L_7$) soit entouré, à une distance correspondant au pas de la self, d'une masse au minimum sur une partie de sa longueur. Les extrémités de cette masse ne doivent pas être reliées entre elles.

4. Circuit de filtrage selon l'une des revendications 1 à 3, comprenant deux branches permettant de découpler séparément les gammes radio et télévision, caractérisé en ce que:
- la branche permettant de découpler la gamme TV soit composée d'une capacité $C_8$ et d'un circuit de résonnance parallèle branché en série $L_5$, $C_9$ formant ainsi la branche longitudinale du circuit, dont la sortie est raccordée d'une part à la prise TV, et d'autre part à un circuit relié à la masse, formant la branche perpendiculaire, composé d'une inductance $L_6$ et d'un circuit de résonnance parallèle branché en série $L_7$, $C_{10}$. Les réactances $L_6$, $L_7$ forment un filtre coupe-bande pour la bande des ondes longues, moyennes et courtes, de même que $L_5$, $C_9$ et $L_6$, $C_{10}$ pour la bande modulation de fréquence. $L_5$, $C_8$ et $L_7$, $C_{10}$ constituent un filtre passe-bande pour la gamme TV I; $C_8$, $C_9$ et $L_6$, $L_7$ forment un filtre passe-haut pour les gammes TV IV/V et que d'autre part:
- la branche permettant de découpler la gamme radio soit composée d'une inductance $L_8$ et d'un circuit de résonnance parallèle branché en série $L_9$, $C_{11}$ formant ainsi la branche longitudinale du circuit, dont la sortie est raccordée d'une part à la prise radio (RF), et d'autre part à un circuit relié à la masse, formant la branche perpendiculaire, composé d'une capacité $C_{13}$ et d'un circuit de résonnance parallèle branché en série $L_{10}$, $C_{12}$. Les réactances $L_8$, $L_9$ et $C_{12}$, $C_{13}$ forment un filtre passe-bas pour la bande des ondes longues, moyennes et courtes; $L_9$, $C_{11}$ et $L_{10}$, $C_{12}$, un filtre coupe-bande pour la bande TV I et $L_8$, $C_{11}$ avec $L_{10}$ et $C_{13}$ un filtre passe-bande pour la gamme modulation de fréquences.

*Fig.1*

*Fig.2*

0 101 789

*Fig.3*

*Fig.4*